# EUROPEAN PATENT APPLICATION

(11) **EP 4 037 101 A1**
(43) Date of publication of application: **03.08.2022**
(21) Application number: 20867083.6
(22) Date of filing: 24.09.2020
(51) Int. Cl.: H01Q 17/00, H05K 9/00, B32B 7/025

(54) **LAMBDA/4 TYPE RADIO WAVE ABSORBER**

(30) Priority: 25.09.2019 JP 2019174459
(71) Applicant: SEKISUI CHEMICAL CO., LTD., Osaka-shi Osaka 530-8565 (JP)
(72) Inventor: NAKAO, Sachiko, Gamagori-shi, Aichi 443-8623 (JP); SAWADAISHI, Tetsurou, Gamagori-shi, Aichi 443-8623 (JP); MUTOU, Katsunori, Gamagori-shi, Aichi 443-8623 (JP)
(74) Representative: Ter Meer Steinmeister & Partner
(86) International application number: PCT/JP2020/035968
(87) International publication number: WO 2021/060352

(57) **Abstract**

The preset invention provides a λ/4 radio wave absorber having excellent radio wave absorption performance.

A radio wave absorber comprising a resistive film, a dielectric layer, and a reflective layer, and having a moisture content determined from the peak area of mass 18 according to a simultaneous thermogravimetric and mass spectrometric analysis measurement of 0.7 mg/cm² or less.

## Description

### Technical Field

The present invention relates to a λ/4 radio wave absorber and related items.

### Background Art

Mobile communication devices such as cellular phones and smartphones have rapidly become widespread. Automobiles, for example, have been equipped with many electronic devices; however, due to radio waves and noise generated from these devices, radio disturbances or malfunctions of other electronic devices frequently occur. To prevent these problems, such as radio disturbances and malfunctions, various radio wave absorbers have been studied. For example, PTL 1 discloses an electromagnetic wave absorber that has a bandwidth of 2 GHz or more in a frequency band of which the absorption of electromagnetic waves is 20 dB or more within the frequency band of 60 to 90 GHz.

### Citation List

### Patent Literature

PTL 1: JP2018-098367A

### Summary of Invention

### Technical Problem

There is a growing demand for radio wave absorbers that can highly absorb high-frequency radio waves for communication and automatic driving technologies over a wide range of frequencies. In the course of research, the inventors found that these radio wave absorbers sometimes have a gap between the absorbable radio wave frequency and design value due to in-plane variations in the sheet resistance of a resistive film, which is one of the components of the radio wave absorber.

Accordingly, an object of the present invention is to provide a λ/4 radio wave absorber having excellent radio wave absorption performance.

### Solution to Problem

As a result of extensive research in view of the above object, the present inventors found that a dielectric layer facing a resistive film has a significant influence on variations in radio wave absorption performance and the sheet resistance value. As a result of further research based on this finding, the inventors found that the above problem can be solved by a λ/4 radio wave absorber that comprises a resistive film, a dielectric layer, and a reflective layer, and that has a moisture content of 0.7 mg/cm² or less, wherein the moisture content is determined from the peak area of mass 18 according to a simultaneous thermogravimetric and mass spectrometric analysis measurement. Based on this finding, the present inventors conducted further research, and accomplished the present invention.

Specifically, the present invention encompasses the following embodiments.
1. A λ/4 radio wave absorber comprising a resistive film, a dielectric layer, and a reflective layer, and having a moisture content determined from the peak area of mass 18 according to a simultaneous thermogravimetric and mass spectrometric analysis measurement of 0.7 mg/cm² or less.
2. The λ/4 radio wave absorber according to Item 1, wherein the resistive film, the dielectric layer, and the reflective layer are stacked in this order.
3. The radio wave absorber according to Item 1 or 2, wherein the resistive film contains molybdenum.
4. The radio wave absorber according to Item 1 or 2, wherein the resistive film contains indium oxide.
5. The radio wave absorber according to any of Items 1 to 4, wherein the sheet resistance of the resistive film is within the range of 200 to 800 Ω/□.
6. The λ/4 radio wave absorber according to any one of Items 1 to 5, wherein the standard deviation of the sheet resistance measured at any 9 points of the resistive film is 5Ω/□ or less.
7. A molded article equipped with an electromagnetic wave absorber, comprising a molded article and the electromagnetic wave absorber according to any one of Items 1 to 6 attached to the molded article.
8. A λ/4 radio wave absorber member comprising a resistive film and a dielectric layer, and having a moisture content determined from the peak area of mass 18 according to a simultaneous thermogravimetric and mass spectrometric analysis measurement of 0.7 mg/cm² or less.

### Advantageous Effects of Invention

The present invention can provide a λ/4 radio wave absorber that is capable of exhibiting a certain level or more of radio wave absorption properties.

### Brief Description of Drawings

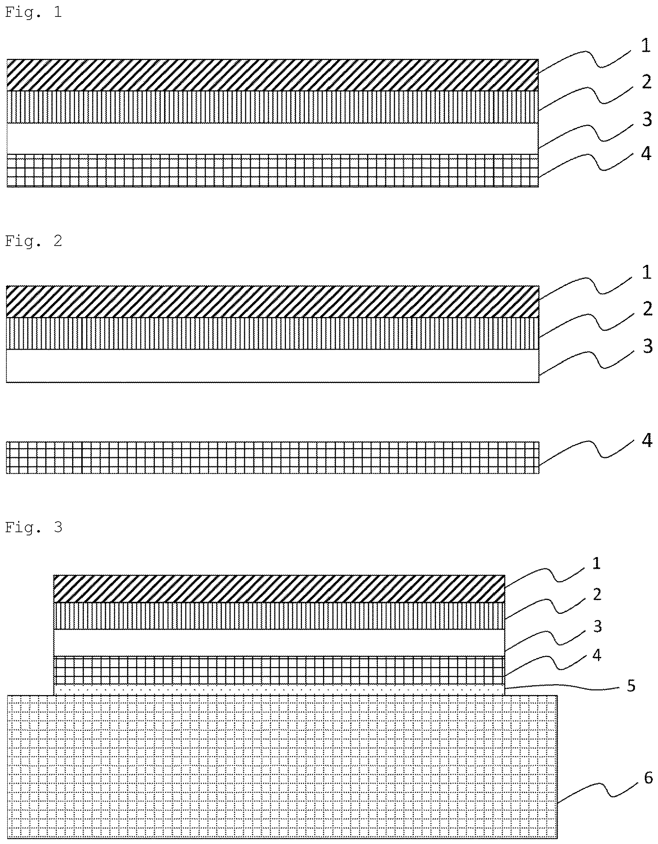

Fig. 1 illustrates the schematic cross-section of the λ/4 radio wave absorber according to an embodiment of the present invention.
Fig. 2 illustrates on the upper side the schematic cross-section of the λ/4 radio wave absorber member according to an embodiment of the present invention, and on the lower side the schematic cross-section of an adherend that is arranged so that the radio wave absorber member comes into contact with the adherend, and that functions as a reflective layer in an embodiment of the invention.
Fig. 3 illustrates a schematic cross-section that illustrates an application of the λ/4 radio wave absorber according to an embodiment of the present invention. (In this embodiment, the λ/4 radio wave absorber is attached to a molded article through an adhesive layer.)

### Description of Embodiments

In the present specification, the terms "comprise," "contain," and "include" includes the concepts of comprising, containing, including, consisting essentially of, and consisting of.

In one embodiment, the present invention relates to a λ/4 radio wave absorber comprising a resistive film, a dielectric layer, and a reflective layer, and having a moisture content determined from the peak area of mass 18 according to a simultaneous thermogravimetric and mass spectrometric analysis measurement of 0.7 mg/cm² or less (sometimes referred to as the "λ/4 radio wave absorber of the present invention"). This λ/4 radio wave absorber is explained below.

### 1. Characteristics

The λ/4 radio wave absorber of the present invention has characteristics in that the moisture content determined from the peak area of mass 18 according to a simultaneous thermogravimetric and mass spectrometric analysis measurement is 0.7 mg/cm² or less (in this specification, sometimes referred to as the characteristics of the present invention) . The λ/4 radio wave absorber having such characteristics ensures excellent radio wave absorption performance. The moisture content is preferably 0.6 mg/cm² or less, and is more preferably 0.5 mg/cm² or less.

In the present invention, it is considered that the radio wave absorption performance is improved because variations in the sheet resistance of the resistive film can be reduced by keeping an outgas generated from the radio wave absorber (especially the dielectric layer facing the resistive film) below a certain level. Accordingly, there is little discrepancy between the absorbable radio wave frequency and the design value, and excellent radio wave absorption performance is attained.

The characteristics of the present invention can be measured, for example, as follows. The radio wave absorber having an arbitrary area is cut, thus obtaining a test piece. The test piece is measured according to simultaneous thermogravimetric and mass spectrometric analysis (TG-MS analysis) under the following conditions.

### Conditions

Device: produced by NETZSCH Japan K.K., product numbers: STA449F1 and QMS403, or an equivalent product
TG measurement conditions: The sample chamber is vacuum-dried at 40°C for 1 minute. Then, the pressure is returned to normal pressure with He; the temperature is increased to 250°C at an increase rate of 10°C/min by introducing the test piece at 50 ml/min; and the temperature is kept at 250°C for 10 minutes.
MS measurement: Scan mode
Line temperature: 250°C

The data obtained from the measurement under the above conditions are analyzed using "Proteus Thermal Analysis" produced by NETZSCH Japan K.K. By forming a graph in which the horizontal axis represents temperature, the first vertical axis represents TG/%, and the second vertical axis represents ion intensity, the peak area of mass (m/z) 18 is calculated. Using a calibration curve, the moisture content (mg/cm²) of the test piece can be determined from the above peak area.

A calcium oxalate monohydrate may be used as a standard sample in preparing the above calibration curve. For example, when a calcium oxalate monohydrate is used as a standard sample, a calibration curve is prepared by the following procedure.

### Procedure

(1) The specific amount of calcium oxalate monohydrate is weighed, followed by heating up to 900°C at 10°C/min.
(2) A chromatogram at mass (m/z) 18 is obtained using "Proteus Thermal Analysis" produced by NETZSCH Japan K.K.
(3) The peak area at 100 to 200°C is calculated.
(4) Measurements of (1) to (3) above are conducted at two to three points by changing the amount of calcium oxalate monohydrate, thus preparing a calibration curve.

The characteristics of the present invention can be adjusted, for example, by adjusting the type of the dielectric layer and the moisture content; and by heating and drying the radio wave absorber.

### 2. Structure

The structure of the λ/4 radio wave absorber of the present invention is not particularly limited as long as the characteristics of the present invention are included. For example, a known structure of a radio wave absorber can be used. In one embodiment, the λ/4 radio wave absorber of the present invention comprises a support, a resistive film, a dielectric layer, and a reflective layer. These embodiments are described below.

### 2-1. Support

When the λ/4 radio wave absorber of the present invention comprises a resistive film, it is preferred that the absorber further includes a support. This protects the resistive film, and increases the durability of the radio wave absorber. The support can be any material in sheet form. Examples of supports include, but are not limited to, resin base materials.

The resin base material refers to a base material that contains resin as a material, and can be any resin material in sheet form. The resin base material may contain components other than resin, to the extent that the effect of the present invention is not significantly impaired. For example, from the standpoint of adjusting relative permittivity or the like, the resin base material may contain titanium oxide. The total content of resin in the resin base material is, for example, 80 mass% or more, preferably 90 mass% or more, more preferably 95 mass% or more, and still more preferably 99 mass% or more; and typically less than 100 mass%.

Examples of resins include, but are not limited to, polyester-based resins, such as polyethylene terephthalate (PET), polyethylene naphthalate, and modified polyester; polyolefin resins, such as polyethylene (PE) resin, polypropylene (PP) resin, polystyrene resin, and cyclic olefin-based resins; vinyl-based resins, such as polyvinyl chloride, polyvinylidene chloride, polyvinylidene fluoride; polyvinyl acetal resins, such as polyvinyl butyral (PVB); polyether ether ketone (PEEK) resin, polysulfone (PSF) resin, polyether sulfone (PES) resin, polycarbonate (PC) resin, polyamide resin, polyimide resin, acrylic resin, and triacetyl cellulose (TAC) resin. These resins can be used singly, or in a combination of two or more.

Of these, from the standpoint of productivity and strength, and from the standpoint of the characteristics of the present invention, polyester-based resins are preferable, and polyethylene terephthalate is more preferable.

The relative permittivity of the support can be any value. The relative permittivity of the support is, for example, 1 to 20, preferably 1 to 15, and more preferably 1 to 10. In particular, the relative permittivity of the support is particularly preferably 1 to 5, from the viewpoint of margin-increase capability due to variations in the film thickness.

The relative permittivity of the support can be measured in the same manner as the relative permittivity of the dielectric layer.

The thickness of the support can be any value. The thickness of the support is, for example, 5 µm or more and 500 µm or less, preferably 10 µm or more and 300 µm or less, and more preferably 20 µm or more and 300 µm or less. In particular, from the viewpoint of the characteristics of the present invention, the thickness of the support is preferably 30 µm or more to 250 µm or less, and more preferably 40 µm or more to 200 µm or less.

The layer structure of the support is not particularly limited. The support may be composed of a single support, or a combination of two or more supports.

### 2-2. Resistive Film

The resistive film can be any resistive film that functions as a resistive layer in radio wave absorbers.

The resistance value of the resistive film is not particularly limited. The resistance value of the resistive film is, for example, 200 to 800 Ω/□. In this range, the resistance value is preferably 220 to 550 Ω/□, and more preferably 250 to 500 Ω/□.

The resistance value of the resistive film can be measured by using a non-destructive (eddy current) sheet resistance/resistivity measurement instrument (EC-80P, produced by Napson Corporation; or an equivalent product).

The thickness of the resistive film is not particularly limited. The thickness of the resistive film is, for example, 1 nm or more to 200 nm or less, preferably 2 nm or more to 100 nm or less, and more preferably 2 nm or more to 50 nm or less.

The layer structure of the resistive film is not particularly limited. The resistive film may be composed of a single resistive layer, or a combination of two or more resistive layers.

### 2-2-1. Resistive Layer

### 2-2-1-1. ITO-Containing Resistive Layer

The resistive layer for use is, for example, indium tin oxide ("ITO" below). In particular, a resistive layer containing ITO that contains 1 to 40 wt%, more preferably 2 to 35 wt% of SnO₂, is preferable for use from the standpoint of the highly stable amorphous structure and suppressed changes in sheet resistance of the resistive film in hot and humid conditions. In the resistive layer, the content of ITO is, for example, 50 mass% or more, preferably 70 mass% or more, more preferably 90 mass% or more, and still more preferably 95 mass% or more; and typically less than 100 mass%.

### 2-2-1-2. Molybdenum-Containing Resistive Layer

The resistive layer for use preferably contains molybdenum from the standpoint of durability and the ease of adjusting sheet resistance. The lower limit of the content of molybdenum is not particularly limited; from the standpoint of increasing durability, the lower limit of the content of molybdenum is preferably 5 wt%, more preferably 7 wt%, still more preferably 9 wt%, yet more preferably 11 wt%, particularly preferably 13 wt%, very preferably 15 wt%, and most preferably 16 wt%. The upper limit of the content of molybdenum is preferably 30 wt%, more preferably 25 wt%, and still more preferably 20 wt%, from the standpoint of the ease of adjusting the surface resistance value.

More preferably, the resistive layer that contains molybdenum further contains nickel and chromium. A resistive layer containing nickel and chromium in addition to molybdenum leads to a radio wave absorber with excellent durability. Examples of alloys containing nickel, chromium, and molybdenum include a variety of alloy grades such as Hastelloy B-2, B-3, C-4, C-2000, C-22, C-276, G-30, N, W, and X.

The resistive layer containing molybdenum, nickel, and chromium preferably contains molybdenum in an amount of 5 wt% or more, nickel in an amount of 40 wt% or more, and chromium in an amount of 1 wt% or more. The resistive film containing molybdenum, nickel, and chromium in amounts within these ranges leads to a radio wave absorber with further improved durability. The resistive film more preferably contains molybdenum in an amount of 7 wt% or more, nickel in an amount of 45 wt% or more, and chromium in an amount of 3 wt% or more. The resistive film still more preferably contains molybdenum in an amount of 9 wt% or more, nickel in an amount of 47 wt% or more, and chromium in an amount of 5 wt% or more. The resistive film yet more preferably contains molybdenum in an amount of 11 wt% or more, nickel in an amount of 50 wt% or more, and chromium in an amount of 10 wt% or more. The resistive film particularly preferably contains molybdenum in an amount of 13 wt% or more, nickel in an amount of 53 wt% or more, and chromium in an amount of 12 wt% or more. The resistive film very preferably contains molybdenum in an amount of 15 wt% or more, nickel in an amount of 55 wt% or more, and chromium in an amount of 15 wt% or more. The resistive film most preferably contains molybdenum in an amount of 16 wt% or more, nickel in an amount of 57 wt% or more, and chromium in an amount of 16 wt% or more. Additionally, the nickel content in the resistive film is preferably 80 wt% or less, more preferably 70 wt% or less, and still more preferably 65 wt% or less. The upper limit of the chromium content is preferably 50 wt% or less, more preferably 40 wt% or less, and still more preferably 35 wt% or less.

The resistive layer may further contain metals other than molybdenum, nickel, or chromium. Examples of such metals include iron, cobalt, tungsten, manganese, and titanium. The upper limit of the total content of metals other than molybdenum, nickel, and chromium in the resistive layer containing molybdenum, nickel, and chromium is preferably 45 wt%, more preferably 40 wt%, still more preferably 35 wt%, yet more preferably 30 wt%, particularly preferably 25 wt%, and very preferably 23 wt% from the standpoint of durability of the resistive layer. The lower limit of the total content of metals other than molybdenum, nickel, and chromium is, for example, 1 wt% or more.

When the resistive layer contains iron, the upper limit of the content of iron is preferably 25 wt%, more preferably 20 wt%, and still more preferably 15 wt%, with the lower limit being preferably 1 wt%, from the standpoint of durability of the resistive layer. When the resistive layer contains cobalt and/or manganese, the upper limit of the content of each metal is independently preferably 5 wt%, more preferably 4 wt%, and still more preferably 3 wt%, with the lower limit being preferably 0.1 wt%, from the standpoint of durability of the resistive layer. When the resistive layer contains tungsten, the upper limit of the content of tungsten is preferably 8 wt%, more preferably 6 wt%, and still more preferably 4 wt%, with the lower limit being preferably 1 wt%, from the standpoint of durability of the resistive layer.

The resistive layer may contain silicon and/or carbon. The resistive layer containing silicon and/or carbon contains silicon and/or carbon in an individual amount of preferably 1 wt% or less, and more preferably 0.5 wt% or less. The resistive layer containing silicon and/or carbon contains silicon and/or carbon in an individual amount of preferably 0.01 wt% or more.

The resistance value of the resistive layer is not particularly limited. The resistance value of the resistive layer is, for example, 200 to 600 Ω/□. Within this range, the resistance value of the resistive layer is more preferably 220 to 550 Ω/□, and even more preferably 250 to 500 Ω/□.

The standard deviation of the sheet resistance measured at any 9 points of the resistance layer is not particularly limited. From the viewpoint of radio wave absorption properties, the standard deviation of the sheet resistance of the resistive layer is preferably 5 Ω/□ or less, more preferably 4 Ω/□ or less, and even more preferably 3 Ω/□ or less. The lower limit of the standard deviation of the sheet resistance of the resistive layer is not particularly limited, and is, for example, 0.01 Ω/□ or more, and preferably 0.1 Ω/□ or more.

The standard deviation of the sheet resistance measured at any 9 points of the resistive layer can be calculated from the sheet resistance values at any 9 points measured by a non-destructive (eddy current method) sheet resistance/resistivity measurement instrument (EC-80P, produced by Napson Corporation; or an equivalent product). The standard deviation of the sheet resistance of the resistive layer can be adjusted according to the moisture content in the radio wave absorber, or the surface roughness of the surface that is in contact with the support of the resistive layer when the radio wave absorber has a support.

The thickness of the resistive layer is not particularly limited. The thickness of the resistive layer is, for example, 1 nm or more to 200 nm or less, preferably 2 nm or more to 100 nm or less, and more preferably 2 nm or more to 50 nm or less.

The layer structure of the resistive layer is not particularly limited. The resistive layer may be composed of a single resistive layer, or a combination of two or more resistive layers.

### 2-2-2. Barrier Layer

From the standpoint of durability, the resistive film preferably includes a barrier layer. The barrier layer is disposed on at least one surface of the resistive layer. The barrier layer is described in detail below.

The barrier layer can be any layer that can protect the resistive layer, and that can suppress degradation of the resistive layer. The material for the barrier layer can be, for example, a metal compound or a metalloid compound; and preferably an oxide of a metal or metalloid, a nitride, or a nitride oxide. The barrier layer may contain components other than these materials, to the extent that the effect of the present invention is not significantly impaired. In this case, the content of the material described above in the barrier layer is, for example, 80 mass% or more, preferably 90 mass% or more, more preferably 95 mass% or more, and still more preferably 99 mass% or more; and typically less than 100 mass%.

Examples of metal elements contained in the barrier layer include titanium, aluminum, niobium, cobalt, and nickel. Examples of metalloid elements contained in the barrier layer include silicon, germanium, antimony, and bismuth.

Examples of oxides of a metal or metalloid element include compounds represented by MOₓ wherein X represents a number that satisfies the formula n/100 ≤ X ≤ n/2 (n representing the valence of a metal or metalloid), and M represents a metal or metalloid element.

Examples of nitrides include compounds represented by MN_{y} wherein Y represents a number that satisfies the formula n/100 ≤ Y ≤ n/3 (n representing the valence of a metal or metalloid), and M represents a metal or metalloid element.

Examples of nitride oxides include compounds represented by MO_{X}N_{y} wherein X and Y satisfy the following: n/100 ≤ X, n/100 ≤ Y, and X + Y < n/2 (n representing the valence of a metal or metalloid), and M represents a metal or metalloid element.

Regarding the oxidation number X of an oxide or nitride oxide, for example, elemental analysis of the cross-sectional surface of a layer containing MOₓ or MOₓN_{y} is performed with an FE-TEM-EDX (e.g., JEM-ARM200F, produced by JEOL Ltd.), and then X is calculated from the element ratio of M and O per area of the cross-sectional surface of the layer containing MOₓ or MOₓN_{y}. From this calculation, the valence of the oxygen atom can be determined.

Regarding the nitridation number Y of a nitride or nitride oxide, for example, elemental analysis of the cross-sectional surface of a layer containing MN_{y} or MOₓN_{y} is performed with an FE-TEM-EDX (e.g., JEM-ARM200F, produced by JEOL Ltd.), and then Y is calculated from the element ratio of M and N per area of the cross-sectional surface of the layer containing MN_{y} or MOₓN_{y}. From this calculation, the valence of the nitrogen atom can be determined.

Specific examples of materials of the barrier layer include SiO₂, SiOₓ, Al₂O₃, MgAl₂O₄, CuO, CuN, TiO₂, TiN, and AZO (aluminum-doped zinc oxide).

The thickness of the barrier layer can be any thickness. The thickness of the barrier layer is, for example, 1 nm or more to 200 nm or less, preferably 1 nm or more to 100 nm or less, and more preferably 1 nm or more to 20 nm or less.

The layer structure of the barrier layer is not particularly limited. The barrier layer may be composed of a single barrier layer, or a combination of two or more barrier layers.

### 2-3. Dielectric Layer

The dielectric layer can be any dielectric layer that can function as a dielectric for a target wavelength in a radio wave absorber. Examples of dielectric layers include, but are not limited to, resin sheets and adhesives.

The resin sheet can be any resin in sheet form that contains resin as a material. The resin sheet may contain components other than resin, to the extent that the effect of the present invention is not significantly impaired. In this case, the total content of resin in the resin sheet is, for example, 50 mass% or more, preferably 70 mass% or more, more preferably 90 mass% or more, and still more preferably 95 mass% or more, and typically less than 100 mass%.

The resin can be any resin, and the resin for use as a resin component is, for example, preferably a synthetic resin, such as ethylene vinyl acetate copolymers (EVA), vinyl chloride, urethane, acrylic, acrylic urethane, polyolefin, polyethylene, polypropylene, silicone, polyethylene terephthalate, polyester, polystyrene, polyimide, polycarbonate, polyamide, polysulfone, polyethersulfone, and epoxy; and a synthetic rubber material, such as polyisoprene rubber, polystyrene-butadiene rubber, polybutadiene rubber, chloroprene rubber, acrylonitrile-butadiene rubber, butyl rubber, acrylic rubber, ethylene-propylene rubber, and silicone rubber. These resins can be used singly, or in a combination of two or more.

The dielectric layer may be a foam or an adhesive. Examples of adhesives include, but are not particularly limited to, acrylic adhesives, urethane adhesives, polyolefin adhesives, polyester adhesives, vinyl alkyl ether adhesives, polyamide adhesives, rubber adhesives, silicone adhesives, and fluorine adhesives. Of these, acrylic adhesives are preferred from the standpoint of excellent weather resistance.

The dielectric layer may have adhesiveness. Thus, when a dielectric with no adhesiveness is stacked on another layer through an adhesive layer, the combination of the dielectric and the adhesive layer forms a dielectric layer. From the standpoint of the ease of stacking a dielectric layer on an adjacent layer, the dielectric layer preferably contains an adhesive layer.

The relative permittivity of the dielectric layer can be any value that satisfies the characteristics of the present invention. The relative permittivity of the dielectric layer is, for example, 1 or more and 20 or less, preferably 1 or more and 15 or less, and more preferably 1 or more and 10 or less. In particular, the relative permittivity of the reflective layer is particularly preferably 1 to 5, from the viewpoint of margin-increase capability due to variations in the film thickness of the dielectric.

The relative permittivity of the dielectric layer can be measured in the range of 1 MHz with a dielectric constant measurement device (E4980AL Precision LCR Meter) produced by Keysight Technologies, and a measurement electrode (DPT-2141-01) produced by Keycom Technologies.

The moisture content of the dielectric layer is not particularly limited as long as the characteristics of the present invention are satisfied. The moisture content of the dielectric layer is preferably 0.5 mg/cm² or less from the viewpoint of the characteristics of the present invention. The lower limit is not particularly limited, and is, for example, 0.1 µg/cm². The moisture content of the dielectric layer can be adjusted according to the kind of components constituting the dielectric layer, by subjecting the dielectric layer to heating or vacuum-drying.

The moisture content of the dielectric layer can be determined in the same manner as the characteristics of the present invention. Specifically, for example, it can be measured as follows. The dielectric layer having an arbitrary area is cut, thus obtaining a test piece. The test piece is measured according to simultaneous thermogravimetric and mass spectrometric analysis (TG-MS analysis) under the following conditions.

### Conditions

Device: produced by NETZSCH Japan K.K., product numbers STA449F1 and QMS403, or an equivalent product
TG measurement conditions: The sample chamber is vacuum-dried at 40°C for 1 minute. Then, the pressure is returned to normal pressure with He; the temperature is increased to 250°C at an increase rate of 10°C/min by introducing the test piece at 50 ml/min; and the temperature is kept at 250°C for 10 minutes.
MS measurement: Scan mode
Line temperature: 250°C

The data obtained from the measurement under the above conditions are analyzed using "Proteus Thermal Analysis" produced by NETZSCH Japan K.K. By forming a graph in which the horizontal axis represents temperature, the first vertical axis represents TG/%, and the second vertical axis represents ion intensity, the peak area of mass (m/z) 18 is calculated. Using a calibration curve, the moisture content (mg/cm²) of the test piece can be determined from the above peak area.

A calcium oxalate monohydrate may be used as a standard sample in preparing the above calibration curve. For example, when a calcium oxalate monohydrate is used as a standard sample, a calibration curve is prepared by the following procedure.

### Procedure

(1) The specific amount of calcium oxalate monohydrate is weighed, followed by heating up to 900°C at 10°C/min.
(2) A chromatogram at mass (m/z) 18 is obtained using "Proteus Thermal Analysis" produced by NETZSCH Japan K.K.
(3) The peak area at 100 to 200°C is calculated.
(4) Measurements of (1) to (3) above are conducted at two to three points by changing the amount of calcium oxalate monohydrate, thus preparing a calibration curve.

The thickness of the dielectric layer can be any thickness that satisfies the characteristics of the present invention. The thickness of the dielectric layer is, for example, 100 to 1000 µm. From the standpoint of the characteristics of the present invention, the thickness of the dielectric layer is preferably 150 to 900 µm, and more preferably 200 to 800 µm.

The thickness of the dielectric layer can be measured by a Nikon DIGIMICRO STAND MS-11C + Nikon DIGIMICRO MFC-101.

The layer structure of the dielectric layer is not particularly limited. The dielectric layer may be composed of a single dielectric layer, or a combination of two or more dielectric layers. Examples include a dielectric layer with a three-layered structure that includes a non-adhesive dielectric and an adhesive layer disposed on each surface of the non-adhesive dielectric, and a dielectric layer with a monolayer structure that includes an adhesive dielectric.

### 2-4. Reflective Layer

The reflective layer can be any layer that functions as a reflective layer for radio waves in a radio wave absorber. Examples of reflective layers include, but are not limited to, metal films.

The metal film can be any metal film that contains metal as a material. The metal film may contain components other than metal, to the extent that the effect of the present invention is not significantly impaired. In this case, the total content of metal in the metal film is, for example 30 mass% or more, preferably 50 mass% or more, more preferably 75 mass% or more, still more preferably 80 mass% or more, yet more preferably 90 mass% or more, particularly preferably 95 mass% or more, and very preferably 99 mass% or more; and typically less than 100 mass%.

The metal can be any metal. Examples of metals include aluminum, copper, iron, silver, gold, chromium, nickel, molybdenum, gallium, zinc, tin, niobium, and indium. Metal compounds, such as ITO, are also usable as a material of metal films. These metals can be used singly, or in a combination of two or more.

The thickness of the reflective layer is not particularly limited. The thickness of the reflective layer is, for example, 1 µm or more and 500 µm or less, preferably 2 µm or more and 200 µm or less, and more preferably 5 µm or more and 100 µm or less.

The layer structure of the reflective layer is not particularly limited. The reflective layer may be composed of a single reflective layer, or a combination of two or more reflective layers.

### 2-5. Layer Structure

When the λ/4 radio wave absorber of the present invention comprises a resistive film, a derivative layer, and a reflective layer, the layers are arranged in such an order as to enable the radio wave absorber to exhibit radio wave absorption performance. In an embodiment, the resistive film, the dielectric layer, and the reflective layer are arranged in this order.

When the λ/4 radio wave absorber of the present invention includes a support, the support, the resistive film, the dielectric layer, and the reflective layer are arranged in this order in an embodiment.

The λ/4 radio wave absorber according to the present invention may contain another layer in addition to the support, the resistive film, the dielectric layer, and the reflective layer. Another layer may be stacked on one surface of the support, the resistive film, the dielectric layer, and/or the reflective layer.

### 3. Production Method

The λ/4 radio wave absorber according to the present invention can be obtained depending on its structure according to or in accordance with various methods, such as a known production method. The λ/4 radio wave absorber according to the present invention can be obtained, for example, by a method including the step of sequentially stacking a resistive film, a dielectric layer, and a reflective layer on a support.

The method for stacking layers can be any method.

The resistive film can be stacked, for example, by sputtering, vacuum deposition, ion plating, chemical vapor deposition, or pulsed laser deposition. Of these, from the standpoint of film thickness controllability, sputtering is preferable. The sputtering can be of any type; examples include DC magnetron sputtering, high-frequency magnetron sputtering, and ion beam sputtering. The sputtering device may be of a batch system, or a roll-to-roll system.

The dielectric layer and the reflective layer can be stacked, for example, by using the adhesiveness of the dielectric layer.

### 4. λ/4 Radio Wave Absorber Member

In one embodiment, the present invention relates to a λ/4 radio wave absorber member comprising a resistive film and a dielectric layer, the λ/4 radio wave absorber member having a moisture content determined from the peak area of mass 18 according to a simultaneous thermogravimetric and mass spectrometric analysis measurement of 0.7 mg/cm² or less. The λ/4 radio wave absorber member is a member for forming a λ/4 radio wave absorber by arranging the dielectric layer so as to come in contact with an adherend such as metal. The resistive film, the dielectric layer, the characteristics of the present invention, and other configurations are as explained for the λ/4 radio wave absorber according to the present invention.

### 5. Application

Due to its ability to absorb undesired electromagnetic waves, the λ/4 radio wave absorber according to the present invention can be suitably used as an optical transceiver or a member for handling radio waves in, for example, next-generation mobile communications systems (5G), short-distance wireless transfer techniques, and the like.

In one embodiment of the present invention, a molded article equipped with a radio wave absorber can be produced by using the λ/4 radio wave absorber of the present invention. The molded article equipped with a radio wave absorber comprises a molded article, and a radio wave absorber attached to the molded article. Examples of the molded article include automobile parts such as a bumper, chassis of radars, and the like.

Alternatively, the radio wave absorber according to the present invention can be used in order to reduce radio wave interference and noise in an intelligent transport system (ITS) that communicates between automobiles, roads, and people; and in millimeter-wave radars for automobile collision prevention systems.

In one embodiment, the present invention relates to a millimeter-wave radar comprising the λ/4 radio wave absorber of the present invention. The frequency of the radio wave targeted by the λ/4 radio wave absorber according to the present invention is preferably 10 to 150 GHz, more preferably 50 to 100 GHz, and even more preferably 70 to 90 GHz.

### Examples

The present invention is described in detail with reference to Examples below. However, the present invention is not limited to the Examples.

### (1) Production of λ/4 Radio Wave Absorber

### Example 1

A polyethylene terephthalate (PET) film having a thickness of 125 µm (relative permittivity: 3.2) was prepared as a support. On this PET film, a resistive film with a sheet resistance value of 375 Ω/□ was formed by DC sputtering. Sputtering was performed using Hastelloy C-276 as a target at an output of 0.4 kW by introducing Ar gas at a flow rate of 100 sccm to adjust the pressure to 0.12 Pa. Subsequently, a dielectric layer formed of a two-sided acrylic adhesive tape with a thickness of 450 µm (non-support type, relative permittivity: 2.6) was stacked on the formed resistive film. Additionally, a reflective layer formed of copper with a thickness of 12 µm was stacked on the other side of the dielectric layer, thereby preparing a λ/4 radio wave absorber. The obtained λ/4 radio wave absorber was placed in an oven, and dried for 6 minutes at a temperature of 110°C.

### Example 2

A λ/4 radio wave absorber was obtained in the same manner as in Example 1, except that the sheet resistance value of the resistive film was changed to the value shown in Table 1, sputtering was performed using an indium tin oxide (SnO₂ content: 2 wt%) as a target at an output of 5.5 kW by introducing a gas in which the ratio of Ar and O₂ was adjusted to 96:4 to adjust the pressure to 0.8 Pa, and the resulting *λ*/4 radio wave absorber was placed in an oven and dried for 3 minutes at a temperature of 110°C.

### Example 3

A λ/4 radio wave absorber was obtained in the same manner as in Example 1, except that the sheet resistance value of the resistive film was changed to the value shown in Table 1, and the resulting *λ*/4 radio wave absorber was placed in an oven and dried for 10 minutes at a temperature of 100°C.

### Example 4

A λ/4 radio wave absorber was obtained in the same manner as in Example 1, except that the sheet resistance value of the resistive film was changed to the value shown in Table 1, sputtering was performed using an indium tin oxide (SnO₂ content: 2 wt%) as a target at an output of 5.5 kW by introducing a gas in which the ratio of Ar and O₂ was adjusted to 96:4 to adjust the pressure to 0.8 Pa, and the resulting *λ*/4 radio wave absorber was placed in an oven and dried for 2 minutes at a temperature of 100°C.

### Example 5

A polyethylene terephthalate (PET) film having a thickness of 125 µm (relative permittivity: 3.2) was prepared as a support. On this PET film, a resistive film with a sheet resistance value of 375 Ω/□ was formed by DC sputtering. Sputtering was performed using Hastelloy C-276 as a target at an output of 0.4 kW by introducing Ar gas at a flow rate of 100 sccm to adjust the pressure to 0.12 Pa. Subsequently, a dielectric formed of a polyimide film having a thickness of 377 µm (relative permittivity: 3.5) was stacked on the formed resistive film via a two-sided acryl tape (relative permittivity: 2.6, thickness: 30 µm). Additionally, a reflective layer formed of copper with a thickness of 12 µm was stacked on the other side of the dielectric layer, thereby preparing a λ/4 radio wave absorber. The obtained λ/4 radio wave absorber was placed in an oven and dried for 1 minute at a temperature of 110°C.

### Example 6

A λ/4 radio wave absorber was obtained in the same manner as in Example 1, except that the sheet resistance value of the resistive film was changed to the value shown in Table 1, and the resulting *λ*/4 radio wave absorber was placed in a vacuum dryer and dried for 3 hours at a pressure of 0.01 Pa.

### Comparative Example 1

A λ/4 radio wave absorber was obtained in the same manner as in Example 1, except that the sheet resistance value of the resistive film was changed to the value shown in Table 1, sputtering was performed using an indium tin oxide (SnO₂ content: 2 wt%) as a target at an output of 5.5 kW by introducing a gas in which the ratio of Ar and O₂ was adjusted to 96:4 to adjust the pressure to 0.8 Pa, and the resulting *λ*/4 radio wave absorber was not dried.

### Comparative Example 2

A λ/4 radio wave absorber was obtained in the same manner as in Example 1, except that the sheet resistance value of the resistive film was changed to the value shown in Table 1, and the resulting *λ*/4 radio wave absorber was placed in an oven and dried for 1 minute at a temperature of 100°C.

### (2) Measurement and Evaluation

### (2-1) Measurement of Moisture Content by Simultaneous

### Thermogravimetric and Mass Spectrometric Analysis Device

The radio wave absorber was cut in a size of 1 cm (length) × 1.3 cm (width), thus obtaining a test piece. The test piece was measured according to simultaneous thermogravimetric and mass spectrometric analysis (TG-MS analysis) under the following conditions.

### Conditions

Device: produced by NETZSCH Japan K.K., product numbers: STA449F1 and QMS403
Amount of sample: 100 mg (1 cm × 1.3 cm)
TG measurement conditions: The sample chamber was vacuum-dried at 40°C for 1 minute. Then, the pressure was returned to normal pressure with He; the temperature was increased to 250°C at an increase rate of 10°C/min by introducing a sample at 50 ml/min; and the temperature was kept at 250°C for 10 minutes.
MS measurement: Scan mode
Line temperature: 250°C

The data obtained from the measurements under the above conditions were analyzed by using "Proteus Thermal Analysis" produced by NETZSCH Japan K.K. By forming a graph in which the horizontal axis represents temperature, the first vertical axis represents TG/%, and the second vertical axis represents ion intensity, the peak area of mass (m/z)18 was calculated. Using a calibration curve, the moisture content (mg/cm²) of the test piece was obtained from the above peak area.

A calcium oxalate monohydrate was used as a standard sample in preparing the above calibration curve, and the calibration curve was prepared by the following procedure.

### Procedure

(1) The specific amount of calcium oxalate monohydrate was weighed, followed by heating up to 900°C at 10°C/min.
(2) A chromatogram at mass (m/z) 18 was obtained using "Proteus Thermal Analysis" produced by NETZSCH Japan K.K.
(3) The peak area at 100 to 200°C was calculated.
(4) Measurements of (1) to (3) above were conducted at three points, i.e., a calcium oxalate monohydrate of 1.4 mg, 4.4 mg, and 9.6 mg, thus preparing a calibration curve.

### (2-2) Standard Deviation of Sheet Resistance

1,000 hours after the preparation of the radio wave absorber, a non-destructive (eddy current method) sheet resistance/resistivity measurement instrument (EC-80P, produced by Napson Corporation) was used to measure the sheet resistance at 9 points (0.5 mm apart from each other) by placing a probe on the side opposite to the side of the support facing the resistive film, and the standard deviation was calculated based on the 9 sheet resistance values.

### (2-3) Measurement of Radio Absorption Performance

An MS4647B network analyzer (Anritsu Corporation) and a BD1-26.A free space material measurement device (Keycom Corporation) were used to construct a radio wave absorption measurement device. Using the radio wave absorption measurement device, the amount of radio wave absorption of the obtained λ/4 radio wave electromagnetic wave absorber at 79 GHz was measured according to JIS R1679. The λ/4 radio wave absorber was set so that the direction of radio wave incidence was vertical and from the support side. The case where the amount of radio wave absorption was 20dB or more was referred to as ○, and the case where the amount of radio wave absorption was less than 20dB was referred to as ×.

### (3) Results

The results are shown in Table 1.

**Table 1**

| | | Example 1 | Example 2 | Example 3 | Example 4 | Example 5 | Example 6 | Comparative Example 1 | Comparative Example 2 |
|---|---|---|---|---|---|---|---|---|---|
| Support | Material | PET | PET | PET | PET | PET | PET | PET | PET |
| | Thickness (*µ*m) | 125 | 125 | 125 | 125 | 125 | 125 | 125 | 125 |
| Resistive film | Material | Hastelloy C-276 | ITO | Hastelloy C-276 | ITO | Hastelloy C-276 | Hastelloy C-276 | ITO | Hastelloy C-276 |
| | Average seat resistance (Ω/□) | 375 | 391 | 370 | 392 | 375 | 375 | 405 | 403 |
| Dielectric layer | Material | Acrylic adhesive tape | Acrylic adhesive tape | Acrylic adhesive tape | Acrylic adhesive tape | polyimide film | Acrylic adhesive tape | Acrylic adhesive tape | Acrylic adhesive tape |
| | Permittivity | 2.6 | 2.6 | 2.6 | 2.6 | 3.5 | 2.6 | 2.6 | 2.6 |
| | Thickness (*µ*m) | 450 | 450 | 450 | 450 | 377 | 450 | 450 | 450 |
| Reflective layer | Kind of metal layer | Cu | Cu | Cu | Cu | Cu | Cu | Cu | Cu |
| | Thickness (µm) | 12 | 12 | 12 | 12 | 12 | 12 | 12 | 12 |
| Physical properties | Moisture content in radio wave absorber (mg/cm²⁾ | 0.4 | 0.6 | 0.3 | 0.7 | 0.6 | 0.3 | 0.8 | 0.75 |
| Physical properties | Standard deviation of sheet resistance (Q/□) | 3 | 4 | 2 | 4 | 4 | 2 | 7 | 6 |
| Evaluation | In-plane variations in the sheet resistance Standard deviation of 5Ω/□ or less | ○ | ○ | ○ | ○ | ○ | ○ | × | × |
| Evaluation | Radio wave absorption performance | ○ | ○ | ○ | ○ | ○ | ○ | × | × |

### Description of the Reference Numerals

- 1: support
- 2: resistive film
- 3: dielectric layer
- 4: reflective layer
- 5: adhesive layer
- 6: molded article

## Claims

1. A λ/4 radio wave absorber comprising a resistive film, a dielectric layer, and a reflective layer, and having a moisture content determined from the peak area of mass 18 according to a simultaneous thermogravimetric and mass spectrometric analysis measurement of 0.7 mg/cm² or less.

2. The λ/4 radio wave absorber according to claim 1, wherein the resistive film, the dielectric layer, and the reflective layer are stacked in this order.

3. The radio wave absorber according to claim 1 or 2, wherein the resistive film contains molybdenum.

4. The radio wave absorber according to claim 1 or 2, wherein the resistive film contains indium oxide.

5. The radio wave absorber according to any of claims 1 to 4, wherein the sheet resistance of the resistive film is within the range of 200 to 800 Ω/□.

6. The λ/4 radio wave absorber according to any one of claims 1 to 5, wherein the standard deviation of the sheet resistance measured at any 9 points of the resistive film is 5Ω/□ or less.

7. A molded article equipped with an electromagnetic wave absorber, comprising a molded article and the electromagnetic wave absorber according to any one of claims 1 to 6 attached to the molded article.

8. A λ/4 radio wave absorber member comprising a resistive film and a dielectric layer, and having a moisture content determined from the peak area of mass 18 according to a simultaneous thermogravimetric and mass spectrometric analysis measurement of 0.7 mg/cm² or less.
